(19) Europäisches Patentamt
European Patent Office
Office européen des brevets

(11) **EP 2 797 103 A1**

(12) **EUROPÄISCHE PATENTANMELDUNG**

(43) Veröffentlichungstag:
**29.10.2014 Patentblatt 2014/44**

(51) Int Cl.:
*H01J 37/32* *(2006.01)* *C23C 14/54* *(2006.01)*
*C23C 14/56* *(2006.01)*

(21) Anmeldenummer: **14172439.3**

(22) Anmeldetag: **26.07.2007**

(84) Benannte Vertragsstaaten:
**FR GB**

(30) Priorität: **02.08.2006 DE 102006036403**

(62) Dokumentnummer(n) der früheren Anmeldung(en)
nach Art. 76 EPÜ:
**07787949.2 / 2 052 403**

(71) Anmelder: **Von Ardenne GmbH**
**01324 Dresden (DE)**

(72) Erfinder:
• **Teichert, Bernd**
**01277 Dresden (DE)**

• **Milde, Falk**
**01109 Dresden (DE)**
• **Teschner, Götz**
**01307 Dresden (DE)**
• **Mädler, Eckehard**
**01187 Dresden (DE)**

(74) Vertreter: **Lippert, Stachow & Partner**
**Patentanwälte**
**Krenkelstrasse 3**
**01309 Dresden (DE)**

Bemerkungen:
Diese Anmeldung ist am 13-06-2014 als
Teilanmeldung zu der unter INID-Code 62 erwähnten
Anmeldung eingereicht worden.

(54) **Verfahren und Vorrichtung zur Beschichtung eines Substrats mit einer definierten Schichtdickenverteilung**

(57) Der Erfindung, die ein Verfahren und eine Vorrichtung zur Beschichtung eines Substrats mit einer definierten Schichtdickenverteilung in einem Vakuumbeschichtungsprozess mittels einer dem Substrat gegenüber liegenden, im wesentlichen kontinuierlich und gleichmäßig betriebenen Beschichtungsquelle betrifft, wobei das Substrat und die Beschichtungsquelle relativ zueinander bewegt werden, liegt die Aufgabenstellung zugrunde, ein Arbeitsverfahren zur Einstellung einer gezielten Schichtdickenverteilung einer Schicht anzugeben, welche in einem Vakuumbeschichtungsprozess auf verschieden geformte Substrat auftragbar ist. Erfindungsgemäß wird die Aufgabe dadurch gelöst, dass das Substrat mittels des ersten Transportsystems oder die Beschichtungsquelle mittels eines zweiten Transportsystems relativ zueinander bewegt werden, wodurch Substrat eine Reihe aufeinander folgender, definierter Positionen relativ zur Beschichtungsquelle einnimmt und in jeder der Positionen eine unabhängig einstellbare Verweilzeit verharrt und dass das Anfahren der Positionen sowie das Verweilen mit der jeweiligen Verweilzeit entsprechend einer positionsabhängigen Verweilfunktion erfolgt.

EP 2 797 103 A1

**Beschreibung**

Die Erfindung betrifft ein Verfahren zur Beschichtung eines Substrats mit einer definierten Schichtdickenverteilung in einem Vakuumbeschichtungsprozess mittels einer dem Substrat gegenüber liegenden, im wesentlichen kontinuierlich und gleichmäßig betriebenen Beschichtungsquelle, wobei das Substrat und die Beschichtungsquelle relativ zueinander bewegt werden. Die Erfindung betrifft ebenso eine Vorrichtung zur Bewegung des Substrats relativ zur Beschichtungsquelle in einer Vakuumbeschichtungsanlage.

Unabhängig davon, mit welchem Prozessregime eine Vakuumbeschichtungsanlage betrieben wird, ob mit diskontinuierlichem Substrattransport zwischen getrennten Prozesskammern oder kontinuierlicher Beschichtung in einer Inline-Beschichtungsanlage, ob die Bewegung des Substrats durch die Anlage geradlinig oder in einer Kreisbewegung an der Beschichtungsquelle vorbeibewegt wird, verursachen eine ganze Reihe von Prozessbedingungen Abweichungen von dem gewünschten Schichtdickenprofil auf dem Substrat. In der Regel soll eine gleichmäßige Verteilung der Schichtdicke erzielt werden, wofür das Substrat relativ zur Beschichtungsquelle mit konstanter Linear- oder Winkelgeschwindigkeit bewegt wird. Es kann auf diese Weise aber auch ein spezielles Profil einzustellen sein.

Insbesondere spezielle Substratformen, zum Beispiel gekrümmte Substrate, die in der Automobilindustrie zur Anwendung kommen, führen zu Abweichungen der Dicke der aufgetragenen Schicht. Ebenso sind Schwankungen in der Prozessgasverteilung während des Substrattransports, der Einfluss des Substrattransports auf die Plasmaentladung, das Design der Beschichtungsanlage selbst und viele weitere, sehr häufig nicht zu bestimmende Faktoren die Ursachen für Abweichungen.

Da eine Vielzahl von Faktoren die Schichtdickenverteilung in sehr komplexer Weise beeinflussen können und häufig bestimmte Faktoren nicht beeinflussbar sind, werden hauptsächlich die Schichtdickenverteilungen durch verschiedene Maßnahmen direkt korrigiert, ohne die Ursachen der festgestellten Abweichungen eindeutig zu bestimmen oder gar zu beheben.

Beispielsweise werden Schwankungen in der Schichtdicke durch Randeffekte der räumlich begrenzten Beschichtungsquelle durch Blenden verringert, was jedoch stets nur eine Korrektur quer zur Transportrichtung ermöglicht.

Auch die Regelung der Plasmaentladung quer zum Substrat, zum Beispiel durch dreifach Plasma-Emissions-Monitoring (PEM) oder die Regelung der Plasmaentladung über PEM in Abhängigkeit der Substratposition sind möglich, jedoch nur auf Reaktivprozesse anwendbar. Eine weitere gängige Methode, um insbesondere komplex geformte Substrate mit einer homogenisierten Schicht zu versehen, ist das Bewegen eines oder mehrerer Substrate, beispielsweise mit komplexen Substratgeometrien, vor einer stationären Beschichtungsquelle. Es kann beispielsweise eine Kalotte mit vielen kleineren Substraten gegenüber der Quelle gedreht werden, wobei die einzelnen Substrate ggf. eine Planetenbewegung ausführen. Die Substrate können auch auf einer Walze sitzen, welche eine Drehbewegung parallel zur Quelle ausführt. In anderen Anordnungen wird ein flaches Substrat außerhalb der Achse einer vergleichsweise kleinen Beschichtungsquelle und parallel dazu gedreht, wobei viel größere Substrate homogen beschichtet werden können als die Charakteristik der Quelle im stationären Fall gestatten würde. Diese Methoden zielen auf eine Mittelung von Inhomogenitäten der Quelle oder Anlage. All diesen Methoden ist gemein, dass die Antriebe mit einer konstanten Geschwindigkeit laufen, wobei im Allgemeinen die Periode der Bewegung viel kleiner ist als die Beschichtungsdauer.

Der Erfindung liegt somit die Aufgabe zugrunde, ein Arbeitsverfahren und eine geeignete Vorrichtung zur Herstellung einer homogenen Schicht in einer Vakuumbeschichtungsanlage auf verschieden geformten Substraten anzugeben, das auch die Einstellung einer gezielten Schichtdickenverteilung einer Schicht ermöglicht.

Diese Aufgabe durch zum einen durch ein Verfahren gelöst, in welchem das Substrat oder die Beschichtungsquelle mittels des zugehörigen ersten oder zweiten Transportsystems relativ zueinander bewegt werden. Infolge der Bewegungen von Substrat oder Beschichtungsquelle nimmt das Substrat erfindungsgemäß eine Reihe aufeinander folgender, definierter Positionen relativ zur Beschichtungsquelle ein und verharrt in jeder der Positionen eine unabhängig einstellbare Verweilzeit, wobei das Anfahren der Positionen sowie das Verweilen mit der jeweiligen Verweilzeit entsprechend einer positionsabhängigen Verweilfunktion erfolgt. Vorteilhafte Ausgestaltungen des Verfahrens sind den Ansprüchen 3 bis 28 zu entnehmen.

Die Abstimmung der Bewegungen beider Beschichtungspartner erfolgt an sich mit der erfindungsgemäßen Verweilfunktion, die den zeitlichen Ablauf der Einnahme bestimmter Relativpositionen zwischen Beschichtungsquelle und Substrat unter Zugrundelegung spezifischer, die Relativpositionen eindeutig bestimmender Parameter beschreibt. Im einfachsten Fall ist solch ein Parameter die unveränderte Position der Beschichtungsquelle. Es ist selbstverständlich, dass die Abstimmung neben dem zeitlichen Ablauf des Anfahrens der Position und des Verweilens in dieser Position auch die Relativpositionen selbst betrifft, so dass eine akzeptable Beschichtung unter Berücksichtigung der in dieser Position erzielbaren Schichtdickenverteilung überhaupt möglich ist.

Die zueinander relative Bewegung des Substrates und der Beschichtungsquelle schließt erfindungsgemäß sehr unterschiedliche Bewegungszustände hinsichtlich des Bewegungsablaufes und der Geschwindigkeit ein. Besonders variabel ist der Positionierungsablauf zu gestalten, wenn die Beschichtungsquelle alternativ zur Bewegung des Substrats mittels eines zweiten Transportsystems bewegt wird. In diesem Fall erfolgt das Abfahren der erfindungsgemäßen Verweilfunktion durch Substrat oder Beschichtungsquelle mittels miteinander synchronisierter Steuerungen der beiden Transportsysteme. Sind mehrere Transportsysteme beteiligt, so wird dem ersten und zweiten Transportsystem eine erste und zweite Verweilfunktion in der Art zugeordnet, dass der zeitliche Verlauf der Relativbewegung zwischen Substrat und Beschichtungsquelle der erfindungsgemäßen Verweilfunktion entspricht. Die erste und zweite Verweilfunktion sind folglich nicht eindeutig bestimmt und sind nach anderen Kriterien frei wählbar.

Ein Kriterium sind beispielsweise die möglichen Bewegungsabläufe, die in der Beschichtungsanlage und/oder mit den Transportsystemen zu realisieren sind. Auch die erzielbaren Geschwindigkeiten, die Dynamik oder die Regelbarkeit der Transportsysteme bestimmen die einzelnen Verweilfunktionen, welche die einzelnen Transportsysteme abfahren. Hier bestehende Beschränkungen können durch die Überlagerung der einzelnen Teilfunktionen zur Realisierung der erfindungsgemäßen Verweilfunktion überwunden werden.

Im Allgemeinen ist vorgesehen, dass sich das Substrat und die Beschichtungsquelle entsprechend der erfindungsgemäßen Verweilfunktion zueinander in zwei Dimensionen bewegen. Die von Substrat und Beschichtungsquelle relativ zueinander während der Beschichtung sequenziell einzunehmenden Positionen werden eingangs festgelegt oder sind anlagentechnisch bestimmt. Häufig wird lediglich das Substrat an der Beschichtungsquelle vorbei bewegt. Auch die Bewegung der Beschichtungsquelle allein erfolgt in verschiedenen Anwendungsfällen, deren Bewegung senkrecht zur Transportrichtung des Substrats durch die Anlage eingeschlossen. Die Bewegungen des Substrats und der Beschichtungsquelle relativ zueinander in einer dieser oder weiterer realisierbaren Richtungen können sowohl gleichläufig, als auch gegenläufig sein und ebenso im Laufe des Beschichtungsprozesses zwischen diesen beiden Zuständen wechseln. Ebenso kann die Transportrichtung auch eine Kreisbewegung sein. Aufgrund der Überlagerung dieser vielfältigen Bewegungen von Beschichtungsquelle und Substrat ergibt sich im Allgemeinen eine beliebige zweidimensionale Relativbewegung.

Die Bewegungen der Beschichtungsquelle und des Substrats und die Richtungen die Bewegung, hängen auch von dem Aufbau und der Arbeitsweise der Vakuumbeschichtungsanlage ab. Die Bewegungsmöglichkeiten der Beschichtungsquelle werden zum Beispiel durch deren Form und Größe, durch den für die Bewegung zur Verfügung stehenden Raum und auch dadurch bestimmt, inwieweit beispielsweise die erforderlichen Blenden und Medienzuführungen (Quellenumgebung) der Bewegung folgen müssen und können. Entscheidend ist im Wesentlichen, ob eine spezielle Vakuumbeschichtungsanlage mit den verschiedensten technischen Voraussetzungen ausgestattet ist, die für das erfindungsgemäße Arbeitsverfahren zum Betreiben der Anlage erforderlich sind, oder ob eine vorhandene Anlage entsprechend deren technischen Möglichkeiten mit einer speziellen Ausgestaltung der Erfindung betrieben wird.

Dies trifft insbesondere hinsichtlich der Bewegung der Beschichtungsquelle senkrecht zu einer Transportrichtung des Substrats zu. Der Erfindung entsprechend kommt es lediglich darauf an, dass infolge der Relativbewegungen zwischen der im wesentlichen gleichmäßig und kontinuierlich betriebenen Beschichtungsquelle und dem Substrat beide Komponenten verschiedene Positionen zueinander einnehmen und in diesen Positionen während des Beschichtungsprozesses verweilen können. Über die Verweilzeit in diesen Positionen wird bei gleichmäßig arbeitender Beschichtungsquelle die gewünschte Schichtdickenverteilung hergestellt.

Unter Verweilen wird im Sinne der Erfindung eine zeitweilige Ruheposition des jeweils betrachteten Beschichtungspartners in der Anlage verstanden, wobei in der Regel Beschichtungsquelle und Substrat gleichzeitig verweilen. Jedoch ist zur Erzielung einer speziellen Schichtdickenverteilung auch das voneinander abweichende Verharren beider Beschichtungspartner denkbar, je nach dem damit erzielbaren Effekt. Dieses Verfahren entspräche dem Beschichten eines sich an der Beschichtungsquelle vorbeibewegenden Substrats, was durch eine besondere, noch zu beschreibende Ausführungsform der Erfindung in variablerer Form ausführbar ist.

Die Steuerung der Transportsysteme in der beschriebenen Weise ist für die verschiedensten bekannten Typen von Vakuumbeschichtungsanlagen möglich. So können insbesondere in diskontinuierlich arbeitenden Vakuumbeschichtungsanlagen mit einzelnen, durch Schleusen miteinander verbundenen Prozesskammern derartige variable Transportabläufe durchfahren werden. Ebenso können kreisförmig bewegte Substrate eine von einer Verweilfunktion gesteuerte Abfolge von Positionen einnehmen. Sofern in einer Inline-Beschichtungsanlage ausreichende Pufferzonen vorhanden sind oder die Relativbewegung vorwiegend durch die bewegte Beschichtungsquelle ausgeführt wird, ist das erfindungsgemäße Arbeitsverfahren auch in solch einer Anlage anwendbar.

Sofern entsprechend einer besonders vorteilhaften Ausführungsform des erfindungsgemäßen Verfahrens der Abstand der aufeinander folgenden Positionen und die Verweilzeiten in jeder Position so klein gewählt werden, dass eine kontinuierliche Bewegung des Substrats oder der Beschichtungsquelle erfolgt und die Verweilfunktion einer Geschwindigkeitsfunktion entspricht, welche die Relativgeschwindigkeit zwischen Substrat und Beschichtungsquelle abbildet, trifft das bisher gesagte auch auf den Fall zu, dass sich das Substrat und die Beschichtungsquelle nicht in einer bestimmten Anzahl relativer Ruhepositionen befindet, sondern sich in einer Relativbewegung entsprechend einer Geschwindigkeitsfunktion zueinander befinden.

Dabei zeichnet sich diese Ausführungsform dadurch gegenüber den bekannten Verfahren aus, dass sich beide Beschichtungspartner mit einer beliebig variablen, jedoch in der Regel nicht konstanten Geschwindigkeit bewegen, sich die Bewegung nicht nur auf das Substrat beschränkt und die Steuerung der Bewegungen mittels einer Funktion der Relativgeschwindigkeit zwischen beiden Beschichtungspartnern über die Zeit erfolgt. Auch in diesem Fall erfolgt die eindeutige Bestimmung der einzelnen Bewegungszustände von Substrat und Beschichtungsquelle durch geeignete Parametrierung.

Die Erzielung spezieller Schichtdickenverteilungen beruht dabei darauf, dass die auf dem Substrat erzielte Schichtdicke sich reziprok zur Geschwindigkeit des relativ zur Beschichtungsquelle bewegten Substrats, im Folgenden Beschichtungsgeschwindigkeit genannt, verhält. Die auf einem konkret vor der Beschichtungsquelle befindlichen Substratareal abgeschiedene Schichtdicke kann deshalb durch die Beschichtungsgeschwindigkeit, welche entsprechend der Sollschichtdicke gewählt wurde, ebenso beeinflusst werden, wie durch eine Verweildauer in dieser Position.

In den beschriebenen Bewegungsabläufen ist das Ergebnis des Beschichtungsprozesses stets eine spezielle Schichtdickenverteilung, beispielsweise eine nahezu homogene Schichtdicke unabhängig von einer Krümmung des Substrats oder vom Verhältnis der Breite der Beschichtungsquelle zu der des Substrats oder ein spezielles, inhomogenes Schichtprofil.

Anordnungsseitig wird die Aufgabe gelöst, indem beide oder zumindest eines der beiden möglichen Transportsysteme über eine Steuerung mit einem Speicher zur Hinterlegung einer Verweil- oder Geschwindigkeitsfunktion verfügen und dass mittels des ersten oder des zweiten Antriebs ein Positionierungsablauf gemäß der Verweil- oder Geschwindigkeitsfunktion zeitecht fahrbar ist. Mit dem einen oder alternativ mit beiden Transportsystemen ist die Bewegung von Substrat oder Beschichtungsquelle relativ zueinander und gemäß der Verweil- oder Geschwindigkeitsfunktion im Verlaufe des Vakuumbeschichtungsprozesses realisierbar. Indem die von der Steuerung des Transportsystems oder der Transportsysteme mittels der hinterlegten Verweil-oder Geschwindigkeitsfunktion verwaltete Laufzeit synchron zu der tatsächlich zur Beschichtung in der jeweiligen Position erforderlichen Zeit ist, ist durch das Abfahren dieser Funktion die gewünschte Schichtdickenverteilung herstellbar.

Die Steuerung der einzelnen Bewegungsabläufe des ersten und zweiten Transportsystems kann dabei über eine gemeinsame oder zwei getrennte Steuerungen abgewickelt werden. Wichtig ist lediglich, dass Teilbewegungen synchronisiert gestartet werden.

Das erste und das zweite Transportsystem muss zu diesem Zweck in der Lage sein, Positionen in definierter Weise anzufahren, welche in der Verweil- oder Geschwindigkeitsfunktion einem oder zwei getrennten Speichern hinterlegt sind und die Funktionen in Echtzeit zu durchlaufen. Zumindest für das Abfahren der Geschwindigkeitsfunktion dienen dazu zumeist solche Antriebe, die mit variabler Geschwindigkeit in definierter Weise fahrbar sind. Mittels der Steuerung wird die jeweilige Geschwindigkeit entsprechend der hinterlegten Geschwindigkeitsfunktion gefahren.

Mit einem ersten und/oder zweiten Antrieb mit konstanter Geschwindigkeit hingegen ist auch dann der Positionierungsablauf entsprechend einer ermittelten Geschwindigkeitsfunktion realisierbar, wenn entsprechend einer anderen Ausgestaltung der Erfindung die Geschwindigkeitsfunktion in einer Kurvenscheibe mechanisch hinterlegt ist. Die Kurvenscheibe setzt in diesem Fall über ihren momentanen Radius die konstante Geschwindigkeit des Antriebs in den erforderlichen Positionierungsablauf um.

Bei dem Abfahren einer Verweilfunktion ist die Frage der variablen Geschwindigkeit von untergeordneter Bedeutung, da die Variation des Schichtauftrags zur Erzielung des Schichtdickenprofils über die Verweilzeiten in den einzelnen Positionen erfolgt. Das Anfahren der Positionen hingegen kann auch mit konstanter Geschwindigkeit erfolgen.

Besonders vorteilhaft zur Realisierung des Positionierungsablaufs mittels der Geschwindigkeitsfunktion aber ebenso auch mittels der Verweilfunktion ist die Verwendung eines Servomotors mit programmierbarem Servoumrichter als Antrieb der ersten und/oder zweiten Transportsystems. Diese Kombination ist hinsichtlich Genauigkeit und Geschwindigkeit anderen Lösungen im Allgemeinen überlegen, da das Anfahren der Positionen besonders präzise erfolgen kann, selbst wenn diese, insbesondere bei sehr inhomogener Ziel- oder Ausgangsschichtdickenverteilung, sehr dicht liegen sollen.

Der programmierbare Servoumrichter als integraler Bestandteil der Servomotorsteuerung ist somit geeignet, unter Einbeziehung von Bedienereingaben, Messwerten oder andere Parametern Abweichungen jeder Ist- von jeder Sollposition so gegen Null zu führen, dass keine Korrekturen vorzunehmen sind. Gleichzeitig wird durch die Wahl der Dichte der Datensätze der Verweil- oder Geschwindigkeitsfunktion die Dichte der Positionen wählbar, wobei ein Datensatz aus der Relativposition des Substrats zur Beschichtungsquelle und der Verweildauer von Substrat und Beschichtungsquelle in dieser Position oder der Geschwindigkeit, die das Substrat in dieser Position haben soll gebildet wird.

Solch ein moderner Antrieb umfasst bereits alle für die Lösung der Steuerungs- bzw. Regelungsaufgabe erforderlichen und aufeinander abgestimmten Komponenten, nämlich einen programmierbaren Speicher zur Hinterlegung der zu steuernden Kurven, eine Positionserfassung, z.B. einen am Antrieb integrierten Inkrementalgeber, welcher entweder direkt, beispielsweise bei einem rotierenden Substrat, oder indirekt, beispielsweise bei der Substratbewegung mittels Rollenantrieb, mit der Substratposition korrespondiert. Entsprechend einer Ausgestaltung ist eine weitere, externe Positionsmessung an anderer Stelle, z.B. direkt am Substrat oder dessen Aufnahme durch ein anderes Messverfahren möglich. Der Positions-Istwert kann dann in den Servoumrichter gespeist werden, so dass weitere Abweichungen, z.B. mechanischer Schlupf des Substrats gegenüber dem Transportsystem, ausgleichbar sind. Darüber hinaus umfasst ein Servomotor einen integrierten Regler, der das Motordrehmoment entsprechend nachregelt und bei gegebener Massenträgheit ggf. vorausberechnet und somit die tatsächliche Position immer nahe der momentanen Zielvorgabe hält.

Ebenso ist auch ein anderer Motor, wie er in vorhandenen Anlagen bereits integriert sein kann und das Substrat mittels einer externen Sollwertvorgabe transportiert, durch entsprechende externe Komponenten an die Ausführung des erfindungsgemäßen Positionierungsablaufs anpassbar. Die Mindestanforderung an den Motor besteht darin, dass Bewegungen in definierter Weise gesteuert werden können. Diese Anforderung erfüllt z.B. ein einfacher Schrittmotor. Die externe Sollwertvorgabe wird von einer externen Steuerung erzeugt, z. B. einem Rechner, einer Speicherprogrammierbaren Steuerung (SPS) oder einen digitalen Signalprozessor (DSP), der nach den entsprechenden Anforderungen hinsichtlich der Geschwindigkeit oder Verweilzeit dimensioniert sein muss. Die Steuerung verfügt ebenfalls über einen Speicher, in dem die Verweil- oder Geschwindigkeitsfunktion hinterlegt wird.

Es ist einzusehen, dass durch das Durchlaufen der Funktion in Echtzeit mittels eines schnellen Rechners oder eines anderen geeigneten, programmierbaren Reglers, gleichartige oder deutlich komplexere Verweil- oder Geschwindigkeitsfunktionen ohne Nachteile beispielsweise hinsichtlich der Dichte der Positionen und mit gleichzeitiger Auswertung der tatsächlichen Relativposition des Substrats hinterlegbar sind. Die Regelung erfolgt dabei aufgrund einer Positionserfassung des Substrats und/oder der Beschichtungsquelle und der Transport des Substrats und/oder der Beschichtungsquelle zu den einzelnen Positionen wird mittels Schrittmotoren realisiert.

Hierfür kann die Positionserfassung entsprechend der Ausstattung der Beschichtungsanlage und der zeitlichen und räumlichen Anforderungen durch verschiedene Verfahren zeitnah erfolgen. Als besonders vorteilhaft erweist sich die Positionserfassung mittels eines Schrittwertgebers Inkrementalgebers am Motor, eines geeigneten Längenmessverfahrens, bei dem die Länge der durch das Substrat oder die Beschichtungsquelle durchfahrenen Strecke bezogen auf einen definierbaren Anfangspunkt gemessen wird, oder mittels Laserpositionsmessung eines Bezugspunktes am Substrat und/oder an der Beschichtungsquelle, entsprechend weiterer Ausführungsformen der Erfindung.

Sofern eine Positionserfassung entsprechend einer Ausgestaltung der Erfindung separat implementiert ist, beispielsweise mittels Inkrementalgeber auf einer Achse oder Laserpositionserfassung des Substrates, ist eine Regelung des Positionierungsablaufs/der Positionierungsabläufe möglich. Zumeist wird eine solche Lösung aufwändiger und langsamer sein als eine integrierte Lösung, bietet aber die Möglichkeit der Anpassung vorhandener Anlagen und mag für Anwendungen mit weniger hohen Anforderungen ausreichend sein.

Eine besonders homogene Schichtdickenverteilung, beispielsweise bei komplexer Substratgeometrie oder ortsabhängiger Beschichtungsrate, oder ein besonders ausgebildetes Schichtprofil ist erreichbar, wenn der Positionierungsablauf des Substrats oder der Beschichtungsquelle in der Beschichtungskammer zumindest ein weiteres Mal durchlaufen wird, wie es in einer weiteren Ausgestaltung der Erfindung vorgesehen ist.

Dabei erfolgt eine Überlagerung der einzelnen, in jedem Durchlauf erzeugten Schichtdickenverteilungen, wobei es von der jeweils nach dem vorigen Beschichtungsdurchlauf vorhandenen und der zu erzielenden Verteilung abhängt, ob die Verweil- oder Geschwindigkeitsfunktionen, welche die nachfolgenden Positionierungsabläufe steuern, für jeden Positionierungsablauf verschieden sind oder zumindest zwei der Verweiloder Geschwindigkeitsfunktionen übereinstimmen.

Eine mehrfache Beschichtung es gleichen Substrates ist z.B. dann erforderlich, wenn mit einem einzelnen Durchlauf die gewünschte Schichtdicke nicht realisierbar ist, weil das Transportsystem eine Mindestgeschwindigkeit erfordert. So kann die mehrfache Beschichtung des gleichen Substrates mit voneinander abweichenden Ausgangspositionen erfolgen, wobei das rückwärtige Abfahren der im Wesentlichen gleichen Verweil- oder Geschwindigkeitsfunktion einen Sonderfall darstellt. In diesem Sinne kann auch ein Pendeln des Substrates vor der Beschichtungsquelle, d.h. ein einfaches oder auch mehrfaches vorwärtiges und anschließend rückwärtiges Abfahren der Verweil- oder Geschwindigkeitsfunktion, realisiert werden.

Es gibt verschiedene Möglichkeiten, eine erfindungsgemäße Verweil- oder Geschwindigkeitsfunktion festzulegen. Eine besonders vorteilhafte Möglichkeit besteht darin, eine beliebige Ausgangsbeschichtung herzustellen und von deren Schichtdickenverteilung ausgehend die nachfolgenden Durchläufe mittels Verweil- oder Geschwindigkeitsfunktionen so zu steuern, dass die Zielverteilung iterativ hergestellt wird. Dabei wird jeweils ein Substrat mit der ersten, frei gewählten und jeder weiteren, im nächsten Iterationsschritt ermittelten Verweiloder Geschwindigkeitsfunktion beschichtet, das erzielte Schichtdickenprofil ermittelt und mit dem gewünschten Profil verglichen.

Die frei gewählte Verweil- oder Geschwindigkeitsfunktion des ersten Beschichtungsdurchlaufs führt zu einer Ausgangsbeschichtung, deren Schichtdickenprofil noch keinen Zusammenhang zum Zielprofil aufweist. Auf der Grundlage dieses ersten Schichtdickenprofils wird die Verweil- oder Geschwindigkeitsfunktion der nachfolgenden Beschichtung eines weiteren Substrates aus der bekannten ersten Beschichtung ermittelt. Dieser Vorgang wird wiederholt und es werden so viele Beschichtungen mit jeweils unbeschichteten Substraten durchfahren, bis die gewünschte Schichtdickenverteilung erzeugt ist. Im einfachsten Fall wird der erste Durchlauf mit einer konstanten, das heißt von der Position des Substrats, auf die Beschichtungsquelle bezogen, unabhängigen Geschwindigkeit oder Verweilzeit erfolgen, wie es in einer Ausgestaltung der Erfindung vorgesehen ist.

Um die Anzahl der erforderlichen Durchläufe und die einzelnen Durchläufe selbst zu optimieren ist es möglich, die Verweil- oder Geschwindigkeitsfunktion jedes nachfolgenden Positionierungsablaufs aus der Verweil- oder Geschwindigkeitsfunktion des davor durchlaufenen Positionierungsablaufs zu ermitteln, indem jeder einer bestimmten Substratposition zugeordnete Wert der Verweilzeit oder der Relativgeschwindigkeit dieses vorherigen Positionierungsablaufs mittels eines Faktors korrigiert wird. Der Faktor zur Ermittlung der Relativgeschwindigkeit entspricht der, vorzugsweise normierten, Schichtdicke, die an dem Substratpunkt gemessen wird, welcher sich bei der betreffenden Substratposition genau gegenüber einem definierten Punkt der Beschichtungsquelle befindet.

Da, wie oben erwähnt, die erzielbare Schichtdicke um so größer ist, je kleiner die relative Geschwindigkeit des Substrats ist, wird mit diesem Verfahren für eine frei wählbare Anzahl der Substratpositionen die Substratgeschwindigkeit in der jeweiligen Position dadurch bestimmt, dass die relative Geschwindigkeit des vorherigen Durchlaufs in genau dieser Position, bezogen auf einen konkreten, gleich bleibenden Punkt der Beschichtungsquelle mit dem Faktor multipliziert wird, der sich als Quotient aus der bisher erzielten Schichtdicke an diesem Substratpunkt und einer Normierungsdicke ergibt.

Damit ermittelt sich die relative Substratgeschwindigkeit jedes weiteren Positionierungsdurchlaufs aus der Beziehung

$$v_{i+1}(x) = v_i(x) * d_i(x) / d_0 \quad ,$$

wobei v(x) die Relativgeschwindigkeit des Substratpunktes x bezogen auf die Beschichtungsquelle ist, wenn sich dieser Punkt x direkt gegenüber der Beschichtungsquelle befindet, d(x) die erzielte Schichtdicke am Substratpunkt x, der Index i ein Zähler für die Iterationsschritte des Beschichtungsverfahrens und $d_0$ die Ziel- bzw. Normierungsschichtdicke ist. d(x) kann auch das Ergebnis einer Mittelwertbildung quer zur Bezugsrichtung sein.

Die Rechenmethode ist eine Näherung, da die Beschichtungsquelle eine endliche Breite hat. Sie funktioniert insbesondere dann besonders gut, wenn die Abmessung der Quelle in Bezugsrichtung klein gegenüber der Substratdimension in Bezugsrichtung ist. Idealerweise wäre die Quelle punkt- oder linienförmig.

Die Anzahl der Substratpositionen sollte so dicht gewählt werden, dass die sich aus allen positionsbezogenen Geschwindigkeiten ergebende Geschwindigkeitsfunktion ausreichend genau bestimmt ist. Die Substratpositionen stellen gewissermaßen die Stützstellen der Geschwindigkeitsfunktion dar. Die Anzahl der Stützstellen ist dann gering, wenn auf einem "gutmütigen", d.h. nur gering gekrümmten Substrat homogene Schichten aufzubringen sind. Wenn hingegen entweder das Substrat z.B. wegen starker Krümmung oder hohem Aspektverhältnis weniger "gutmütig" ist oder die Zielfunktion große Gradienten aufweist, dann werden viele Stützstellen notwendig sein.

Auch wenn zu berücksichtigen ist, dass sich die Beziehung zwischen Verweildauer und erzielbarer Schichtdicke genau umgekehrt zu der Beziehung zwischen Substratgeschwindigkeit und Schichtdicke verhält, lässt sich die Verweildauerfunktion in vergleichbarer Weise aus den Verweilzeiten in einer bestimmten Anzahl von Substratpositionen durch Korrektur der Verweilzeiten bei dem vorherigen Durchlauf in diesen Positionen bestimmen. Es ist in diesem Fall jedoch ein dem Verhältnis entsprechend modifizierter Faktor zu wählen, nämlich der reziproke Wert der gemessenen, gegebenenfalls normierten Dicke.

Indem die Substratposition stets auf die Beschichtungsquelle bezogen wird, sind verfahrensgemäß die Relativbewegungen zwischen Substrat und Beschichtungsquelle relevant und werden die verschiedensten, eingangs beschriebenen Bewegungszustände berücksichtigt.

Eine andere Möglichkeit der Herstellung einer Ausgangsbeschichtung besteht darin, dass das Substrat in einem ersten Durchlauf durch die Beschichtungskammer bewegt und dieser Durchlauf entsprechend einer Verweil- oder Geschwindigkeitsfunktionen gesteuert wird, die aus einer durch eine geeignete mathematische Simulation ermittelten Schichtdickenverteilung eines Beschichtungsprozesses abgeleitet ist. Durch die Simulationsergebnisse, die es erlauben qualitative und quantitative Vorhersagen über die Eigenschaften und speziell über die Schichtdicken der deponierten Schichten zu treffen, sollen Voreinstellungen der Prozessparameter bestimmt werden, mit denen die gewünschte oder eine günstige anfängliche Schichtdickenverteilung zumindest näherungsweise erzielt wird.

Mit Hilfe mathematischer Simulationen, beispielsweise der bekannten Kinetischen Monte-Carlo-Simulation, wird das Schichtwachstum unter Berücksichtigung bestimmter, näherungsweiser Annahmen beschrieben, indem die Gasstreuung der Partikel von der Quelle zum Substrat und die Elementarereignisse eines Beschichtungsvorganges, wie Deposition und Oberflächendiffusion, entsprechend ihrer Häufigkeit simuliert werden. Dieses Verfahren hat den Vorteil, dass bei geeigneter Wahl des Simulationsverfahrens eine optimalere Ausgangsbeschichtung und eine Minimierung der notwendigen experimentellen Durchläufe für die Erzielung der gewünschten Schichtdickenverteilung erreichbar sind.

Ein besonderer Fall liegt vor, wenn die Bahn der Relativbewegung zwischen Substrat und Beschichtungsquelle zu einer Ausdehnung von Substrat oder Beschichtungsquelle parallel verläuft, und quer zur Bewegungsrichtung des Substrats relativ zur Beschichtungsquelle keine oder nur geringfügige Schwankungen der Schichtdicke zu erwarten sind. Eine solche spezielle Relativbewegung kann für den Beschichtungsprozess gewissermaßen als eindimensionale Relativbewegung des Substrats angesehen werden. Das ist beispielsweise der Fall bei einer geradlinigen Bewegung des Substrats durch eine Beschichtungsanlage, bei einer geradlinigen Bewegung einer ebenen Quelle über einem ebenen Substrat oder einer Rotation eines Substrats um eine im Wesentlichen zylindrische Quelle oder umgekehrt. Liegen beide der oben genannten Bedingungen vor, genügt es, für die iterative Ermittlung der Verteilungs- oder Geschwindigkeitsfunktion nur einen schmalen Substratstreifen in jener Bezugsrichtung zu betrachten, die durch die Richtung der eindimensionalen Relativbewegung des Substrats bezogen auf die Beschichtungsquelle definiert ist.

In diesem Fall kann entsprechend einer Ausgestaltung der Erfindung die erste und jede weitere Verweil- oder Geschwindigkeitsfunktion aus einer eindimensionalen Schichtdickenverteilung in Richtung der Relativbewegung des Substrats, d.h. der Bezugsrichtung, bezogen auf einen definierten Punkt der Beschichtungsquelle, ermittelt wird. Durch den Bezug auf einen definierten Punkt der Beschichtungsquelle, beispielsweise den geometrischen Mittelpunkt jener dem Substrat gegenüber liegenden Oberfläche der Beschichtungsquelle, wird die Relativbewegung eindeutig definiert, trotzdem die Beschichtungsquelle keine punkt- oder linienförmige Ausdehnung hat. Die Ermittlung der Verweil- oder Geschwindigkeitsfunktion vereinfacht sich hier deutlich, so dass es vorteilhaft ist, eine solche Bahn der Relativbewegung durch geeignete Wahl der Bewegungen von Substrat und Beschichtungsquelle zu realisieren.

Sind hingegen Schwankungen der Schichtdicke quer zur Bezugsrichtung vorhanden, so kann das Verfahren zur Funktionsfindung durch eine Mittelung der Schichtdicken über schmale Substratstreifen quer zur Bezugsrichtung ebenfalls auf eine eindimensionale Betrachtung reduziert werden. Die Iteration erfolgt auch hier mit dem oben beschriebenen Verfahren, wobei die Schichtdickenverteilung tatsächlich die Verteilung von gemittelten Schichtdicken und folglich d(x) der Mittelwert der Schichtdicken des Substratstreifens quer zur Bezugsrichtung ist.

Insbesondere, wenn bei der beschriebenen besonderen Relativbewegung eine spezielle Schichtdickenverteilung quer zur Bezugsrichtung gewünscht oder mit herkömmlichen Verfahren erzielt wird, ist es möglich, dass mehrere korrigierte, sich auf einen Substratstreifen beziehende Verweil- oder Geschwindigkeitsfunktionen aus den Positionen gebildet werden, welche jeweils den Schichtdickenverteilungen solcher Substratpositionen entsprechen, die in einer Linie parallel zur oben definierten Bezugsrichtung liegen, und die Verweil- oder Geschwindigkeitsfunktionen des gesamten Substrats durch eine gewichtete Mittelung der streifenweisen Verweil- oder Geschwindigkeitsfunktionen gebildet wird. Die gemittelte Geschwindigkeitsfunktion stellt einen Kompromiss dar, und die Aufgabe besteht darin, die Wichtungsfaktoren so zu wählen, dass alle oder zumindest bevorzugte Schichtdickenverteilungen für die Substratstreifen innerhalb des vorgegebenen Toleranzbandes liegen

Das Substrat wird in dieser wie auch in den zuvor beschriebenen Ausgestaltungen in parallel zur Bezugsrichtung liegende Streifen unterteilt betrachtet. Für jeden dieser Streifen wird eine Verweil- oder Geschwindigkeitsfunktion ermittelt, indem in der oben beschriebenen Weise eine bereits erzielte Schichtdickenverteilung durch Einzelfaktoren korrigiert wird. Die Mittelung über diese streifenweisen und im Allgemeinen voneinander abweichenden Funktionen erlaubt eine Optimierung der Gesamtverteilung in Richtung der gewünschten Lösung. Durch die erfindungsgemäße Wichtung der Einzelfunktionen werden bestimmte Bereiche des Substrats bevorzugt optimiert.

Es ist möglich die Faktoren, welche die streifenweisen Verweil- oder Geschwindigkeitsfunktionen für die Mittelung wichten (Wichtungsfaktoren), so zu wählen, dass aus der gemessenen Schichtdickenverteilung eine erzielbare Schichtdickenverteilung prognostiziert und die Abweichung zwischen der prognostizierten und der Sollschichtdickenverteilung minimiert wird.

Die Kenntnis der unter definierten Prozessparametern der Vakuumbeschichtungsanlage in einem oder wenigen ersten Durchläufen erzielbaren Schichtdickenverteilung lässt eine Prognose der mit dieser Anlage erzielbaren Verteilung zu, so dass die Ermittlung der Wichtungsfaktoren, mit der eine minimale Abweichung der erzielbaren von der gewünschten Schichtdickenverteilung möglich ist, ein üblicher mathematischer Optimierungsprozess, beispielsweise die Minimierung der kleinsten Abweichungsquadrate zwischen prognostizierter und gewünschter Schichtdickenverteilung, ist.

Wenn die durch die beschriebene Korrektur ermittelte Verteilungs- oder Geschwindigkeitsfunktion über die Breite des Substrats hinaus fortgesetzt wird, ist erreichbar, dass durch die begrenzte Breite der Beschichtungsquelle im Randbereich des Substrats auftretende Schichtdickenabweichungen korrigiert werden, ohne eine für diesen Bereich gesonderte Fehlerbetrachtung oder Wichtung vornehmen zu müssen. Die Substratbewegung erfolgt in vielen Fällen, insbesondere in einer Inline-Beschichtungsanlage, über den gesamten Beschichtungsbereich hinweg, während die Quelle meist eingeschalten bleibt und in der Regel, aber nicht notwendig, mit konstanter Leistung betrieben wird. Die zuvor beschriebenen Methoden liefern einen Algorithmus für die Ermittlung der Substratbewegung innerhalb der Grenzen, in denen sich das Substrat oder zumindest ein Teil davon direkt gegenüber der Quelle befindet. Regelmäßig erfolgt jedoch schon eine Beschichtung im Ein- und Auslaufbereich der Beschichtungsstation. Deshalb kann es erforderlich sein, die Geschwindigkeitsfunktion auch in diesen angrenzenden Bereichen fortzusetzen. Das kann zum einen dadurch erfolgen, dass die Geschwindigkeitsfunktion mit konstanter Geschwindigkeit entsprechend dem Profil an einem Randpunkt des Substrats, vorzugsweise am äußersten Punkt, fortgesetzt wird. Eine andere Möglichkeit besteht darin, das Geschwindigkeitsprofil zu extrapolieren, wobei dies nicht nur linear erfolgen muss. Die Extrapolation erfolgt über ungefähr jene Breite, in der die Quelle noch wirksam ist. Letztere Möglichkeit kommt insbesondere dann zur Anwendung, wenn das Substrat am Rand geringe Krümmungen aufweist sowie die Geschwindigkeitsfunktion sich am Rande des Substrates im Rahmen geringer Toleranzen ändert.

Es ist ebenso möglich, die Schichtdickenverteilung entlang der Transportrichtung des Substrats durch die Anlage automatisch durch eine geeignete, während des Transportprozesses ablaufende Messmethode erfasst wird und aus den Messdaten automatisch eine korrigierte, positionsabhängige Verweil- oder Geschwindigkeitsfunktion für die nachfolgende Beschichtung ermittelt wird, wobei als nachfolgend sowohl eine erneute Beschichtung desselben Substrats oder Substratstreifens als auch die nacheinander folgende Beschichtung eines neuen Substrats bezeichnet sein kann.

Auf diese Weise kann sowohl bei dem oben beschriebenen Pendeln eines Substrats, beispielsweise wenn aufgrund der minimal fahrbaren Relativgeschwindigkeit die gewünschte Schichtdicke nicht in einem Durchlauf erreichbar ist, als auch bei den einzelnen Positionsabläufen zur iterativen Ermittlung der Verweil- oder Geschwindigkeitsfunktion, die nachfolgende Verweil- oder Geschwindigkeitsfunktion automatisiert ermittelt werden. Dies ermöglichen neben den bekannten und automatisierbaren Optimierungsverfahren insbesondere die in der Beschichtungstechnik in situ ausführbaren Schichtdickenmessverfahren.

Es werden die verschiedensten, als Schichtdicken-Monitore bekannte in-situ-Messverfahren zur Bestimmung der Schichtdicke im laufenden Beschichtungsprozess angewendet, um den laufenden Prozess zu beeinflussen. Da das erfindungsgemäße Verfahren auf Relativbewegungen zwischen Substrat und Beschichtungsquelle beruht, erweist sich die Einführung des das Substrat betrachtenden Messsystems nur dann als eindeutig definiert, wenn dessen Positionierung eindeutig bestimmbar ist. Aus diesem Grund ist die in-situ-Schichtdickenmessung auf die Transportrichtung beschränkt, indem das Messsystem eine feste Position in der Vakuumbeschichtungsanlage einnimmt und sich das Substrat an diesem vorbeibewegt.

Eine weitere Möglichkeit der Herstellung einer Ausgangsbeschichtung besteht darin, dass eine Reihe stationärer Schichtdickenverteilungen hergestellt werden, indem jede stationäre Schichtdickenverteilung der Beschichtung des Substrats in jeweils einer bestimmten, unveränderten Position bezüglich der Beschichtungsquelle entspricht oder speziell nacheinander mehrere Beschichtungen jeweils eines gegenüber der Beschichtungsquelle unbewegtem Substrats für eine Reihe verschiedener Substratpositionen ausgeführt werden und anschließend die Verweil- oder Geschwindigkeitsfunktionen rechnerisch durch Superposition der stationären Schichtdickenverteilungen und Variation der Koeffizienten ermittelt wird.

Diese Verfahrensweise entspricht gewissermaßen der Zerlegung des oben beschriebenen Beschichtungsprozesses eines einzigen von Position zu Position bewegten Substrats in eine der Anzahl der Positionen entsprechende Vielzahl von stationär durchgeführten Prozessen an einem Substrat mit jeweils anschließender Schichtdickenmessung oder speziell in diese Anzahl stationär beschichtete Einzelsubstrate. Die verschiedenen einzelnen Schichtdickenverteilungen werden anschließend mit einem üblichen Verfahren superpositioniert und so die Funktion der Verweildauer für jede der Positionen und auch weiterer Zwischenpositionen oder die Geschwindigkeitsfunktion für einen Durchlauf ermittelt. Dies erfolgt, indem die Koeffizienten der superpositionierten Schichtdickenverteilung mit einem geeigneten Alghorithmus, z.B. Downhill simplex, solange variiert werden, bis die superpositionierte Schichtdickenverteilung der Zielverteilung möglichst nahe kommt, d.h. die Differenz zwischen beiden bildet ein Minimum. Dann entsprechen die Koeffizienten den Verweilzeiten und deren Reziprokwert einer Geschwindigkeit.

Ebenso ist es wiederum möglich, dass auch jede einzelne stationäre Schichtdickenverteilung aus einer durch eine mathematische Simulation ermittelten Schichtdickenverteilung eines Beschichtungsprozesses mit unbewegtem Substrat in der betreffenden Position abgeleitet ist, wobei in der oben beschriebenen Art die Prozessparameter für jeden stationären Beschichtungsprozess entsprechend der einzelnen Simulationsergebnisse festgelegt werden.

Die Erfindung soll nachfolgend anhand eines Ausführungsbeispiels näher erläutert werden. Im Ausführungsbeispiel werden eine große Anzahl von stationären Schichtdickenverteilungen auf einem Substrat rechnerisch ermittelt und anschließend daraus eine Geschwindigkeitsfunktion ermittelt, mit welcher der Transport des Substrats durch die Beschichtungsanlage zu dessen Beschichtung gesteuert wird.

Dafür werden eine gewählte Anzahl von stationären Schichtdickenverteilungen rechnerisch ermittelt, wobei die Beschichtung einer entsprechenden Anzahl von Substraten in stets unterschiedlicher Position des Substrats, bezogen auf die ortsfeste Beschichtungsquelle, in der dem geeigneten mathematischen Modell entsprechenden räumlichen Winkel- und Abstandsabhängigkeit rechnerische simuliert wird. Die Positionen werden dabei so gewählt, dass ein gedachtes sequentielles Durchfahren dieser Positionen einem Durchlauf eines einzelnen Substrats durch die Beschichtungskammer der Anlage für eine vollständige Beschichtung entspricht.

Für die Berechnung der Schichtdickenverteilungen sind verschiedene, nicht näher beschriebene Modelle bekannt. Im vorliegenden Ausführungsbeispiel wird ein solches verwendet, das die gesamte Beschichtungsquelle in eine große Anzahl einzelner Punktquellen zerlegt betrachtet. Mittels des Modells wird für jeden Substratpunkt eines Substrates sowie für jedes Substrat in seiner definierten Substratposition unter Berücksichtigung der jeweiligen geometrischen Verhältnisse durch Integration über alle Punkte der Beschichtungsquelle die Schichtdicke ermittelt. Hierbei werden zum Beispiel die Auftreffwinkel, die Abschattung durch Blenden oder das Substrat selbst berücksichtigt. Durch erweiternde, zusätzliche Parameter oder durch die Wahl eines anderen geeigneten Modells, beispielsweise die Kinetische Monte-Carlo-Simulation, kann in bekannter Weise auch die Gasstreuung in der Beschichtungskammer berücksichtigt und somit eine bessere Annäherung an die tatsächlich zu erreichende Schichtdicke bewirkt werden.

Im Ergebnis der mathematischen Ermittlung der Schichtdicken sind beschichtbare und unbeschichtbare Substratformen bereits vorselektierbar.

Alternativ zur mathematischen Ermittlung können die Schichtdickenverteilungen auch experimentell durch tatsächliche Beschichtung der Anzahl der Substrate in einer Vakuumbeschichtungsquelle stationär mit einer definierten, für jedes Substrat gleichen Zeit beschichtet werden.

Anschließend werden die berechneten oder tatsächlich hergestellten und gemessenen Schichtdickenverteilungen aller Substrate summiert und dabei durch eine Verweilzeit in der entsprechenden Relativposition gewichtet. Die als Wichtungsfaktoren dienenden Verweilzeiten werden rechnerisch ermittelt, indem der Satz der Verweilzeit in jeder Substratposition dahingehend mit einem geeigneten, nicht näher beschriebenen Optimierungsalgorithmus, beispielsweise das bekannte Downhill-Simplex-Verfahren, variiert wird, dass die durch gewichtete Summation ermittelte Schichtdickenverteilung innerhalb vorgegebener Toleranzen mit der zu erzielenden Schichtdickenverteilung übereinstimmt. Dafür sind geeignete Randbedingungen zu definieren, zum Beispiel muss die Verweilzeit größer Null sein oder Verweilzeiten für benachbarte Substratpositionen dürfen sich nur um einen zu definierenden Maximalbetrag unterscheiden, um Sprünge in der Transportgeschwindigkeit zu unterdrücken, welche aufgrund der Trägheit des Systems bzw. des verfügbaren Drehmoments der Antriebe eine obere Grenze aufweisen.

Die Verweilfunktion ist damit der Satz der durch Optimierung ermittelten Verweilzeiten in Abhängigkeit von der jeweiligen Substratposition. Da die Verweilzeit indirekt proportional zur Relativgeschwindigkeit zwischen Substrat und Quelle ist, kann aus der nach dem oben beschriebenen Verfahren ermittelten Verweilfunktion eine Geschwindigkeitsfunktion ermittelt werden.

Diese Geschwindigkeitsfunktion wird in einem schnellen Rechner hinterlegt, der durch Abfahren dieser Funktion in Echtzeit den Transport eines Substrates durch eine Vakuumbeschichtungsanlage mit ortsfester und gleichmäßig arbeitender Beschichtungsquelle mittels Servomotoren steuert, wobei die Positionserfassung des Substrats zeitnah durch einen Inkrementalgeber am Motor erfolgt.

**Patentansprüche**

1. Verfahren zur Beschichtung eines Substrats mit einer definierten Schichtdickenverteilung in einem Vakuumbeschichtungsprozess mittels einer dem Substrat gegenüber liegenden, im wesentlichen kontinuierlich und gleichmäßig betriebenen Beschichtungsquelle, wobei das Substrat und die Beschichtungsquelle relativ zueinander bewegt werden, **dadurch gekennzeichnet, dass** das Substrat mittels eines ersten Transportsystems oder die Beschichtungsquelle mittels eines zweiten Transportsystems bewegt werden, wodurch das Substrat eine Reihe aufeinander folgender, definierter Positionen relativ zur Beschichtungsquelle einnimmt und in jeder der Positionen eine unabhängig einstellbare Verweilzeit verharrt und dass das Anfahren der Positionen sowie das Verweilen mit der jeweiligen Verweilzeit (Positionierungsablauf) entsprechend einer positionsabhängigen Verweilfunktion erfolgt.

2. Verfahren zur Beschichtung eines Substrats nach Anspruch 1 oder 1, **dadurch gekennzeichnet, dass** der Abstand der aufeinander folgenden Positionen und die Verweilzeiten in jeder Position so klein gewählt werden, dass eine kontinuierliche Bewegung des Substrats und/oder der Beschichtungsquelle erfolgt und die Verweilfunktion einer Geschwindigkeitsfunktion entspricht, welche die Relativgeschwindigkeit zwischen Substrat und Beschichtungsquelle abbildet.

3. Verfahren zur Beschichtung eines Substrats nach einem der Ansprüche 1 oder 2, **dadurch gekennzeichnet, dass** der Positionierungsablauf des Substrats oder der Beschichtungsquelle in der Beschichtungskammer zumindest ein weiteres Mal durchlaufen wird und zumindest eine der Verweil- oder Geschwindigkeitsfunktionen, welche die Positionierungsabläufe steuern, von einer anderen Startposition des Substrates in Bezug auf die Beschichtungsquelle aus abgefahren wird, als die vorangegangene Verweil- oder Geschwindigkeitsfunktion.

**4.** Verfahren zur Beschichtung eines Substrats nach einem der Ansprüche 1 bis 3, **dadurch gekennzeichnet, dass** die Verweil- oder Geschwindigkeitsfunktion ermittelt wird, indem eine Ausgangsbeschichtung mit einem ersten Positionierungsablauf eines ersten Substrats entsprechend einer frei wählbaren, ersten Verweil- oder Geschwindigkeitsfunktion hergestellt und die erzielte Schichtdickenverteilung bestimmt wird, eine weitere Verweil- oder Geschwindigkeitsfunktion eines nachfolgenden Positionierungsablaufs eines weiteren Substrats aus der bekannten Verweil- oder Geschwindigkeitsfunktion des davor durchlaufenen Positionierungsablaufs ermittelt und abgefahren wird und dieser iterative Prozess so oft wiederholt wird, bis ein Substrat die gewünschte Schichtdickenverteilung aufweist.

**5.** Verfahren zur Beschichtung eines Substrats nach Anspruch 4, **dadurch gekennzeichnet, dass** die frei gewählte Verweil- oder Geschwindigkeitsfunktion des ersten Beschichtungsdurchlaufs zu einer Ausgangsbeschichtung führt, deren Schichtdickenprofil noch keinen Zusammenhang zum Zielprofil aufweist.

**6.** Verfahren zur Beschichtung eines Substrats nach Anspruch 4 oder 5, **dadurch gekennzeichnet, dass** die Verweil- oder die Geschwindigkeitsfunktion jedes nachfolgenden Positionierungsablaufs aus der Geschwindigkeitsfunktion des davor durchlaufenen Positionierungsablaufs ermittelt wird, indem jeder einer bestimmten Position zugeordnete Wert der Verweilzeit beziehungsweise der Relativgeschwindigkeit dieses vorherigen Positionierungsablaufs mittels eines Faktors korrigiert wird, welcher der, vorzugsweise normierten, Schichtdicke entspricht, die an dem Substratpunkt gemessen wird, welcher sich bei der betreffenden Positionierung genau gegenüber einem definierten Punkt der Beschichtungsquelle befindet.

**7.** Verfahren zur Beschichtung eines Substrats nach einem der Ansprüche 4 bis 6, **dadurch gekennzeichnet, dass** eine Ausgangsbeschichtung hergestellt wird, indem das Substrat in einem ersten Positionierungsablauf durch die Beschichtungskammer bewegt wird, der entsprechend einer Verweil- oder Geschwindigkeitsfunktionen gesteuert wird, die aus einer durch eine geeignete mathematische Simulation ermittelten Schichtdickenverteilung eines Beschichtungsprozesses abgeleitet ist.

**8.** Verfahren zur Beschichtung eines Substrats nach einem der Ansprüche 4 bis 6, **dadurch gekennzeichnet, dass** eine Ausgangsbeschichtung hergestellt wird, indem das Substrat in einem ersten Positionierungsablauf durch die Beschichtungskammer bewegt wird und dabei die Verweildauer in jeder Position oder die Geschwindigkeit im Wesentlichen konstant ist.

**9.** Verfahren zur Beschichtung eines Substrats nach einem der Ansprüche 4 bis 8, **dadurch gekennzeichnet, dass** sich Substrat und Beschichtungsquelle relativ zueinander auf einer Bahn bewegen, die zu einer Ausdehnung von Substrat oder Beschichtungsquelle parallel verläuft, und dass die erste und/oder jede weitere Verweil- oder Geschwindigkeitsfunktion aus einer eindimensionalen Schichtdickenverteilung in Richtung der Relativbewegung des Substrats (Bezugsrichtung), bezogen auf einen definierten Punkt der Beschichtungsquelle, ermittelt wird.

**10.** Verfahren zur Beschichtung eines Substrats nach einem der Ansprüche 4 bis 8, **dadurch gekennzeichnet, dass** sich Substrat und Beschichtungsquelle relativ zueinander auf einer Bahn bewegen, die zu einer Ausdehnung von Substrat oder Beschichtungsquelle parallel verläuft, und dass die erste und/oder jede weitere Verweil- oder Geschwindigkeitsfunktion aus einer eindimensionalen Schichtdickenverteilung in Bezugsrichtung ermittelt werden, bezogen auf einen definierten Punkt der Beschichtungsquelle, welche durch Mittelung über jene Schichtdicken mehrerer, zur Bezugsrichtung paralleler Substratstreifen ermittelt wird, welche auf definierten Substratstreifen quer zur Bewegungsrichtung liegen.

**11.** Verfahren zur Beschichtung eines Substrats nach einem der Ansprüche 4 bis 8, **dadurch gekennzeichnet, dass** sich Substrat und Beschichtungsquelle relativ zueinander auf einer Bahn bewegen, die zu einer Ausdehnung von Substrat oder Beschichtungsquelle parallel verläuft, und dass die erste und/oder jede weitere Verweil- oder Geschwindigkeitsfunktion aus mehreren Verweil- oder Geschwindigkeitsfunktionen ermittelt werden, welche wiederum aus mehreren parallelen, eindimensionalen Schichtdickenverteilungen ermittelt werden (streifenweise Verweil- oder Geschwindigkeitsfunktion) und die erste und jede weitere Verweil- oder Geschwindigkeitsfunktionen durch eine gewichtete Mittelung der streifenweisen Verweil- oder Geschwindigkeitsfunktionen gebildet wird.

**12.** Verfahren zur Beschichtung eines Substrats nach einem der Ansprüche 1 bis 3, **dadurch gekennzeichnet, dass** die Verweil- oder Geschwindigkeitsfunktionen aus einer Reihe von stationären Schichtdickenverteilungen rechnerisch durch Superposition ermittelt wird und jede stationäre Schichtdickenverteilung der Beschichtung des Substrats in jeweils einer bestimmten, unveränderten Position bezüglich der Beschichtungsquelle entspricht.

**13.** Vorrichtung zur Bewegung eines Substrats relativ zu einer Beschichtungsquelle in einer Vakuumbeschichtungsanlage mit einem ersten, einen ersten Antrieb umfassenden Transportsystem zur Bewegung des Substrats oder einem zweiten, einen zweiten Antrieb umfassenden Transportsystem zur Bewegung der Beschichtungsquelle, **dadurch gekennzeichnet, dass** mit dem ersten und/oder mit dem zweiten Antrieb eine variable Geschwindigkeit fahrbar ist und das erste oder das zweite Transportsystem über eine Steuerung mit einem Speicher zur Hinterlegung einer Verweil- oder Geschwindigkeitsfunktion verfügen und dass mittels des ersten oder des zweiten Antriebs ein Positionierungsablauf gemäß der Verweil- oder Geschwindigkeitsfunktion zeitecht fahrbar ist.

**14.** Vorrichtung zur Bewegung eines Substrats relativ zu einer Beschichtungsquelle nach Anspruch 13, **dadurch gekennzeichnet, dass** das erste und/oder das zweite Transportsystem über einen Regler zur Regelung der Position des Substrats relativ zur Beschichtungsquelle entsprechend der erfassten aktuellen Position sowie der vorgegebenen Geschwindigkeitsfunktion verfügen.

**15.** Vorrichtung zur Bewegung eines Substrats relativ zu einer Beschichtungsquelle nach Anspruch 13, **dadurch gekennzeichnet, dass** der erste/und oder der zweite Antrieb einen Servomotor mit programmierbarem Servoumrichter umfasst.

**16.** Vorrichtung zur Bewegung eines Substrats relativ zu einer Beschichtungsquelle nach Anspruch 13, **dadurch gekennzeichnet, dass** eine Geschwindigkeitsfunktion in einer Kurvenscheibe hinterlegt ist.

**Europäisches Patentamt**
**European Patent Office**
**Office européen des brevets**

# EUROPÄISCHER RECHERCHENBERICHT

Nummer der Anmeldung

EP 14 17 2439

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 1 293 586 A (FRAUNHOFER GES FORSCHUNG [DE]) 19. März 2003 (2003-03-19) * Absätze [0007], [0010], [0014]; Abbildung 1 * ----- | 1,2,13 | INV. H01J37/32 C23C14/54 C23C14/56 |
| X | BELKIND A: "Cosputtering and serial cosputtering using cylindrical rotatable magnetrons", JOURNAL OF VACUUM SCIENCE AND TECHNOLOGY: PART A, Bd. 11, Nr. 4, Part I, Juli 1993 (1993-07) , Seiten 1501-1509, XP000403753, AVS/AIP, MELVILLE, NY [US] ISSN: 0734-2101, DOI: 10.1116/1.578692 * Seite 1502; Abbildungen 1,2 * ----- | 13-16 | |
| A | WO 2004/036616 A (UNAXIS BALZERS AG [LI]; ZÜGER OTHMAR [LI]) 29. April 2004 (2004-04-29) * Seite 6, Zeile 26 - Seite 9, Zeile 24; Abbildung 1 * * Seite 22, Zeilen 15-18 * * Seite 30, Zeile 28 - Seite 32, Zeile 2 * ----- | 1-16 | |
| A | EP 0 674 337 A1 (BOC GROUP INC [US]) 27. September 1995 (1995-09-27) * Spalte 1, Zeile 33 - Spalte 7, Zeile 14; Abbildungen 1-6 * ----- | 1-16 | RECHERCHIERTE SACHGEBIETE (IPC) H01J C23C |
| A | WO 02/075015 A (4WAVE INC [US]) 26. September 2002 (2002-09-26) * Seite 2, Zeile 16 - Seite 4, Zeile 6; Abbildung 1 * ----- | 1-16 | |
| A | US 2002/046946 A1 (SHIMODA KAZUNORI [JP] ET AL) 25. April 2002 (2002-04-25) * das ganze Dokument * ----- -/-- | 1-16 | |

Der vorliegende Recherchenbericht wurde für alle Patentansprüche erstellt

| Recherchenort | Abschlußdatum der Recherche | Prüfer |
|---|---|---|
| München | 17. September 2014 | Hoyer, Wolfgang |

Europäisches
Patentamt

European
Patent Office

Office européen
des brevets

**EUROPÄISCHER RECHERCHENBERICHT**

Nummer der Anmeldung

EP 14 17 2439

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | DE 103 93 678 T (NAT INST OF ADVANCED IND SCIEN [JP]) 15. September 2005 (2005-09-15) * Absatz [0008] * ----- | 1-16 | |

RECHERCHIERTE SACHGEBIETE (IPC)

Der vorliegende Recherchenbericht wurde für alle Patentansprüche erstellt

| Recherchenort | Abschlußdatum der Recherche | Prüfer |
|---|---|---|
| München | 17. September 2014 | Hoyer, Wolfgang |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument
.......................................................................................
& : Mitglied der gleichen Patentfamilie, übereinstimmendes
Dokument

EPO FORM 1503 03.82 (P04C03)

13

## ANHANG ZUM EUROPÄISCHEN RECHERCHENBERICHT
## ÜBER DIE EUROPÄISCHE PATENTANMELDUNG NR.

EP 14 17 2439

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

17-09-2014

| Im Recherchenbericht angeführtes Patentdokument | | Datum der Veröffentlichung | Mitglied(er) der Patentfamilie | | Datum der Veröffentlichung |
|---|---|---|---|---|---|
| EP 1293586 | A | 19-03-2003 | DE | 10145050 C1 | 21-11-2002 |
| | | | EP | 1293586 A2 | 19-03-2003 |
| WO 2004036616 | A | 29-04-2004 | AT | 538489 T | 15-01-2012 |
| | | | AU | 2003266908 A1 | 04-05-2004 |
| | | | CN | 1714422 A | 28-12-2005 |
| | | | EP | 1552544 A1 | 13-07-2005 |
| | | | JP | 4728644 B2 | 20-07-2011 |
| | | | JP | 2006503181 A | 26-01-2006 |
| | | | KR | 20050070047 A | 05-07-2005 |
| | | | US | 2006124446 A1 | 15-06-2006 |
| | | | US | 2008210549 A1 | 04-09-2008 |
| | | | WO | 2004036616 A1 | 29-04-2004 |
| EP 0674337 | A1 | 27-09-1995 | CA | 2143777 A1 | 24-09-1995 |
| | | | DE | 69516747 D1 | 15-06-2000 |
| | | | DE | 69516747 T2 | 28-12-2000 |
| | | | EP | 0674337 A1 | 27-09-1995 |
| | | | ES | 2145213 T3 | 01-07-2000 |
| | | | JP | H0853764 A | 27-02-1996 |
| | | | US | 5616225 A | 01-04-1997 |
| WO 02075015 | A | 26-09-2002 | US | 2002131182 A1 | 19-09-2002 |
| | | | WO | 02075015 A1 | 26-09-2002 |
| US 2002046946 | A1 | 25-04-2002 | JP | 3760370 B2 | 29-03-2006 |
| | | | JP | 2002060938 A | 28-02-2002 |
| | | | US | 2002046946 A1 | 25-04-2002 |
| DE 10393678 | T | 15-09-2005 | AU | 2003277601 A1 | 07-06-2004 |
| | | | CN | 1726300 A | 25-01-2006 |
| | | | DE | 10393678 B4 | 21-11-2013 |
| | | | DE | 10393678 T5 | 15-09-2005 |
| | | | JP | 4441687 B2 | 31-03-2010 |
| | | | KR | 20050086435 A | 30-08-2005 |
| | | | US | 2006246211 A1 | 02-11-2006 |
| | | | WO | 2004042110 A1 | 21-05-2004 |

EPO FORM P0461

Für nähere Einzelheiten zu diesem Anhang : siehe Amtsblatt des Europäischen Patentamts, Nr.12/82